# EUROPEAN PATENT APPLICATION

(11) **EP 4 443 171 A1**
(43) Date of publication of application: **09.10.2024**
(21) Application number: 23167154.6
(22) Date of filing: 06.04.2023
(51) Int. Cl.: G01R 1/067, G01R 3/00

(54) **PROBE FOR USE IN A PROBE SYSTEM FOR PROBING A SUPERCONDUCTIVE CIRCUIT, METHOD OF PROBING AND OF MANUFACTURING A PROBE**

(71) Applicant: Nederlandse Organisatie voor toegepast-natuurwetenschappelijk Onderzoek TNO, 2595 DA 's-Gravenhage (NL)
(72) Inventor: MICHALAK, David Jason, 2595 DA 's-Gravenhage (NL); WILLIGERS, Timo Jean Jozef, 2595 DA 's-Gravenhage (NL)
(74) Representative: V.O.

(57) **Abstract**

The invention is directed at a probe for use in a probe system for probing a superconductive circuit including at least one quantum device, wherein the quantum device comprises a probe pad made of first material for enabling measuring of a parameter of the quantum device; wherein under cryogenic device operating conditions the first material is a superconductor, and wherein the probe is configured for probing the probe pad for performing said measuring, wherein the probe comprises a probe tip configured to be brought in contact with a contact surface of the probe pad; and wherein the probe tip, on a side thereof which is configured to be brought in contact with the contact surface of the probe pad, comprises on an outer layer which is made of a second material, which second material is same as the first material.

## Description

### Field of the invention

The present invention is directed at a probe for use in a probe system for probing a superconductive circuit including at least one quantum device, wherein the quantum device comprises a probe pad made of first material for enabling measuring of a parameter of the quantum device; wherein the first material is a superconductor under the cryogenic device operating conditions, and wherein the probe is configured for probing the probe pad for performing said measuring, wherein the probe comprises a probe tip configured to be brought in contact with a contact surface of the probe pad. The invention is further directed at method of probing a superconductive circuit using such a probe, and a method of manufacturing a probe.

### Background

Chips designed for quantum computing applications contain probe pads composed of non-standard materials and/or non-standard fabrication methods. This leads to contaminations of various nature. As a result, quantum chips are much more challenging to measure using the normal automated methods currently available on probe stations. Reliability of measurement results is thereby compromised, and this complicates automation of this process. This challenge is magnified during lowtemperature (cryogenic) measurement conditions.

In superconducting circuits, probe pads are often made of superconductive materials: i.e. material exhibiting superconductivity under the ambient conditions wherein these circuits are operated (below the critical temperature of these superconductive materials). However, many times the contact surfaces of such probe pads may be contaminated or may have surface properties that easily give rise to probe pollution over time in use. For example, surface roughness and hardness may cause the typically tungsten probes to wear, leaving fragments thereof on the contact surface (e.g. to be picked up by a next probe at a later stage) or on the probe tip itself. The fragments on the surface may also lead to reduced performance of the superconducting circuits themselves during cryogenic operation.

Existing solutions for example include applying sufficient force between the probe needle and the pad such that the needle scratches along the probe pad surface, thereby cleaning off pollution from the surface. This is referred to as 'over travel'. Although this improves the measurements results, this is not achieved consistently and thus still leaves the measuring process to be insufficiently reliable.

### Summary of the invention

It is an object of the present invention to overcome the difficulties and disadvantages of conventional methods and systems, and provide for a reliable solution for probing a superconductive circuit including a quantum device for enabling the measuring of an observable or parameter thereof.

To this end, in accordance with a first aspect of the invention, there is provided herewith a probe as described above, wherein the probe tip, on a side thereof which is configured to be brought in contact with the contact surface of the probe pad, comprises on an outer layer which is made of a second material, which second material is same as the first material.

The probe in accordance with the present invention, for performing the probing, comprises a probe tip provided with an outer layer which is made of the same superconductive material as the contact surface of the probe pad to be probed. In addition to the superconductive properties of the outer layer itself, this further improves the contact conductivity other ways. For example, as a result, the hardness of the probe tip and the contact surface will be the same, such as to minimize wear to either of these and thereby reduce the amount of surface pollution on the probe tip and the contact surface. Furthermore, if any fragments of the (sensitively thin) probe tip may break off, these fragments themselves are superconductive and thereby not assumed to reduce the performance of the device at cryogenic temperature.

In some embodiments, the outer layer of the second material is a coating, wherein the second material is a material suitable for being applied using a deposition method. For example, In some of these embodiments, the deposition method is atomic layer deposition (ALD). ALD has the advantage of being self-limiting, and thus enables the outer layer to be very thin. For example, the thickness of the outer layer may well be below 400 nanometer, for example somewhere between 10 nanometer and 300 nanometer. In other or further embodiments, the deposition method may include chemical vapour deposition. In yet further embodiments, the deposition method is a physical vapour deposition process, such as sputtering or evaporation. The latter two deposition processes may be applied in combination with a wider range of materials, and for these reasons may provide suitable alternatives in cases where ALD cannot be applied.

In some embodiments, the second material is selected from a group comprising: niobium titanium nitride (NbTiN), niobium nitride (NbN), tintanium nitride (TiN), niobium (Nb) and tantalum (Ta). In particular, niobium titanium nitride (NbTiN), niobium nitride (NbN), tintanium nitride (TiN) may preferably but not exclusively be applied by means of an ALD process. Furthermore, these materials make good contact with tungsten, from which material many (but not all) probe tip are made. As a result, these materials can follow the topography of the tip and get into micro-cracks or nanovoids. Therefore, these materials (NbTiN, NbN, TiN) provide for a high quality (strong and highly electrically conductive) and uniform coating on tungsten probe tips. In combination with non-tungsten probe materials (such as beryllium-copper alloy, rhenium-tungsten alloy, osmium, or other materials) these coating layers will still provide high quality probes for the purpose of superconductive circuit testing or read-out. Furthermore, NbTiN, NbN and TiN are also some of the hardest materials available (scoring around 8 or 9 on the Mohs hardness scale) and as a result are not expected to chip or crack off, or be deposited as contamination on the rough surface of the NbTiN of the probe pad of the quantum device.

On the other hand, the use of niobium (Nb) or tantalum (Ta) as second material may be considered. Although these materials are softer than NbTiN and are therefore expected to be more easily left behind on the contact surface of probe pads, these materials are nevertheless reasonable hard (scoring around 6 to 7 on the Mohs hardness scale) and are therefore able to scratch through an oxide layer on the surface. Furthermore, both materials are superconductors with reasonably high Tc values and quantum devices fabricated with these materials have shown, in some cases, to have good coherence times. Therefore, these materials are advantageous for use in superconductive circuits as well as for the outer layer of the probe tip of the present invention. Niobium and tantalum are currently not known to be suitable for being deposited by ALD and as a result would need to be evaporated or sputtered on the probe tips. Although if ALD deposition of these materials becomes possible in the future, then this could be also be used for coating of these materials.

In some embodiments, the probe is made of a third material different from the second material. However, this is not necessarily be the case, the probes may alternatively be completely made of the second material (although apart from their hardness and superconductivity this may not always provide optimal probe properties (e.g. flexibility or structural integrity)). In some embodiments wherein the probe is made of a third material different from the second material, the third material is at least one of: tungsten (W), beryllium copper (BeCu), tungsten rhenium (WRe), osmium (Os), gold (Au), gold plated tungsten, or copper (Cu) or a grade of steel. The probes may be single probe structures, which e.g. extend from a probe chip, probe card or other structure. The probes may also be part of a multi-probe structure, such as a sensing probe device comprising at least two probes, wherein each probe of the at least two probes comprises a probe tip, such as to provide the at least two electrically separated probe tips. This for example enables to measure contact resistance of the contact surface of the probe pad, e.g. prior to measurement of a parameter of the probe device. The probes may also be arranged in a ground-signal-ground (G-S-G) arrangement necessary for RF and/or microwave property testing. Furthermore, the probes in their design could also include any of the industry standard probe cards, RF probe geometries, or true Kelvin needle geometries. Furthermore, the sensing probe device may be a cryogenic probe device including cooling means for maintaining the probe and probe tips in use at a cryogenic temperature. Cryogenic probes allow to maintain the necessary cryogenic conditions for maintaining the probe tip below the critical temperature for superconductive behavior. These probes are often used for probing superconductive circuits, for sensing a parameter of quantum chips or quantum devices therein.

In accordance with a second aspect, there is provided a method of probing a superconductive circuit including at least one quantum device for measuring of a parameter of the quantum device, wherein the quantum device comprises a probe pad made of first material, wherein the first material is configured for becoming superconductive under cryogenic conditions at a temperature below a critical temperature associated with the first material; the method comprising the steps of: probing the probe pad using a probe according to the first aspect, wherein the probe comprises a probe tip and wherein the probing is performed by bringing the probe tip in contact with a contact surface of the probe pad; wherein the probe tip, on a side thereof which is configured to be brought in contact with the contact surface of the probe pad, comprises on an outer layer which is made of a second material, which second material is same as the first material.

In accordance with a third aspect, there is provided a method of manufacturing a probe according to the first aspect, for probing a superconductive circuit including at least one quantum device for measuring of a parameter observable of the quantum device, wherein the quantum device comprises a probe pad made of first material, wherein the first material is configured for becoming superconductive under cryogenic conditions at a temperature below a critical temperature associated with the first material; the method comprising the steps of: providing a probe including a cantilever and a probe tip made of a third material; and depositing, on the probe tip, on a side thereof which is configured to be brought in contact with a contact surface of the probe pad, an outer layer which is made of a second material, which second material is same as the first material.

### Brief description of the drawings

The invention will further be elucidated by description of some specific embodiments thereof, making reference to the attached drawings. The detailed description provides examples of possible implementations of the invention, but is not to be regarded as describing the only embodiments falling under the scope. The scope of the invention is defined in the claims, and the description is to be regarded as illustrative without being restrictive on the invention. In the drawings:
Figure 1 schematically illustrates a probing of a superconductive circuit comprising quantum devices;
Figure 2 schematically illustrates probing of a probe pad using a conventional probe;
Figures 3a and 3b schematically illustrate a probe having a coated probe tip in accordance with an embodiment of the present invention;
Figure 4 schematically illustrates a method of probing a probe pad of a superconductive circuit in accordance with an embodiment of the present invention.

### Detailed description of the figures

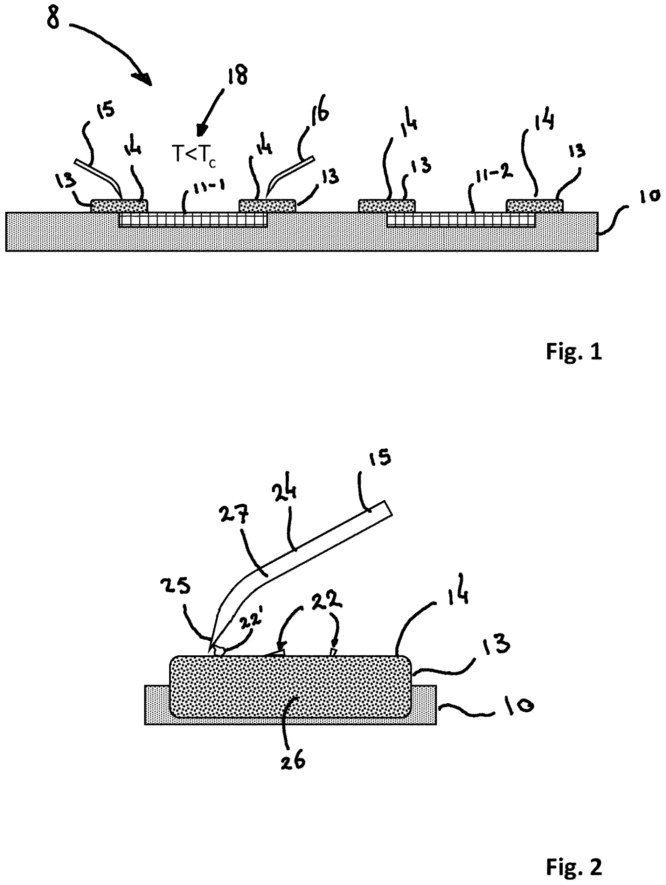

Figure 1 schematically illustrates a silicon wafer substrate 10 in cross section. The silicon wafer 10 comprises a superconductive circuit 8 including a plurality of quantum devices 11, of which two quantum devices 11-1 and 11-2 are visible. The superconductive circuit 8 is operated at a temperature T being lower than the critical temperature T_{c} of the superconducting material of which the circuit 8 is made, as indicated in figure 1 (ref. #18). Each of the devices 11-1 and 11-2 is connected to a first and a second probe pad 13, but more probe pads may also be present. The probe pads 13 allow to measure a parameter of the devices 11-1 and 11-2. For example, the parameter could be (but is not limited to) the measurement of electrical resistance across a Josephson junction, a plurality of Josephson junctions arranged either in electrical series or electrical parallel, the impedance, the capacitance or the inductance of a device, and/or the RF or microwave properties of the chip, such as S-parameters. These measurements are often performed at room temperature, although naturally also measurements at cryogenic temperatures may be performed, for example at temperatures below the critical temperature T_{c} where the circuit 8 is superconductive. To do so, as is illustrated for device 11-1, a first sensing probe 15 and the second sensing probe 16 is brought in contact with either one of the respective probe pads 13 of the device 11-1. As may be appreciated, although in the figure each of the devices 11-1 and 11-2 includes two probe pads 13, some quantum devices may be measured using only a single probe pad, for example relative to an electric ground electrode. Or there may be more than 2 probe pads, for example 4 probe pads, or 6 probe pads, etc. A measuring of parameters of such types of quantum devices, via a single probe pad 13, may be performed in a similar manner.

The signals obtained via the probes 15 and 16 enable to determine a parameter of the quantum device 11-1 of the superconductive circuit 8. However, to probe the quantum device 11-1, very weak signals are typically applied in order to obtain a reliable measurement of the parameter. Therefore, in order to be able to reliably measure the parameter of the quantum device 11-1, a sufficiently good conductive contact with the probe tip 13 needs to be established for each of the first and second sensing probe device 15 and 16. If the contact impedance becomes too large, the weak signals cannot be properly measured. Although for the probe pads 13, superconducting materials are applied as materials from which these are made, the probes 15 and 16 used in conventional setups are typically made of tungsten (W). Tungsten is a relatively hard material (scoring 7.5 on the Mohs hardness scale), but the superconductive materials of which the probe pads 13 may be made is in many cases harder. For example, titanium nitride (TiN) has a hardness score of 9 on the Mohs scale, which is close to that of diamond (scoring 10 on this scale). Therefore, the scratching performed using the probe 15 in order to condition the contact surface 14 to establish good contact, may cause small fragments or chips of the probe 15 to be released on the surface. These may increase the contact resistance and thereby hamper the measurement, or the residual fragments may lead to poor device performance at cryogenic temperatures.

Figure 2 schematically illustrates the probing of a probe pad 13 with a conventional probe 24 with probe tip 25. Probe pad 13 is of superconductive material 26. For example, the superconductive material (i.e. `first material' in the appended claims) 26 may be any of NbTiN, TiN, NbN, Ta or Nb. To establish contact, the probe 15 typically engages contact with the probe pad 13 on the contact surface 14 thereof. However, various factors may negatively influence the conductance of the established contact between the probe 24 and the probe pad 13. For example, the contact surface 14 may be covered with an insulating oxide layer. The oxide layer may locally increase the electrical resistance of the surface 14. Another typical problem, as illustrated in figure 2, is that the contact surface 14 may be covered with contaminations 22. For example, fragments 22 from the probe tip 25 may have come off from the tip 25 and thereafter increase the contact resistance. Also, the probe 24 may have picked up such contaminations 22 from an earlier contact engagement with the same or a different probe pad 13. If the contaminations 22 cover the probe tip 25, such as contamination 22', contact engagement of the probe 24 with the surface 14 of probe pad 13 may not lead to a satisfactory contact resistance. To resolve this, upon engaging contact between the probe 24 and the probe pad 13, the probe tip 25 may be moved across the contact surface 14 over an additional excess length. This is called `overtravel' of the probe tip 25 on the surface 14, and may improve the conductance of the contact experienced. However, it may likewise result in additional contaminations 22 to the probe tip 25 for example because debris from the probe tip 25 itself may build up on the probe tip 25. Therefore, the applied method is no guarantee for success. Apart from such fragments 22, pollution of different origin may be present on the surface. For example, other surface pollution includes residual materials remaining from imperfection in fabrication. The surface could be contaminated with residual resist, hard mask material, adventitious hydrocarbon materials, dust, or other materials deliberately or not-deliberately put onto the surface of the superconductor during fabrication. Even when the fabrication process does not leave behind such foreign contaminants, the surface of the superconduct may grow native oxides under ambient conditions (lab air), and such oxide may need to be scratched off in order to make good electrical contact with the superconductor below.

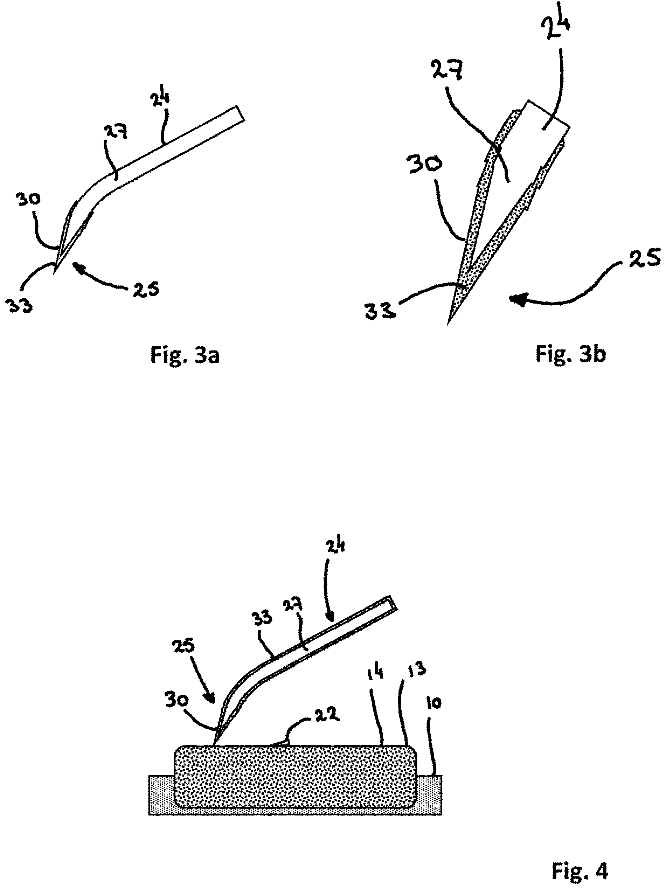

Figures 3a and 3b schematically illustrate a probe 24 in accordance with an embodiment of the invention. The material 27 of which the probe 24 is primarily made is tungsten (W). The probe 24 has an outer layer 30 which is made of a superconducting material 33. The superconducting material 33 is selected to be the same material as the superconductive material 26 of which the probe pad 13 is made of. For example, this preferably may be any of NbTiN, TiN or NbN, as these materials may be deposited on the probe tip 25 using atomic layer deposition, thereby enabling an extremely thin coating. Furthermore, these materials make good contact with tungsten (W), i.e. the material 27 of which probe 24 is made. As a result, these materials can follow the topography of the tip 25 and get into micro-cracks or nanovoids. Therefore, these materials (NbTiN, NbN, TiN) provide for a high quality (strong and highly electrically conductive) and uniform coating 30 on tungsten probe tip 24. Alternatively, the complete probe 24 may have been coated with the superconductive material 33, or even the probe 24 may be manufactured from such material integrally.

Alternatively, the material 33 of the outer layer 30 may be niobium (Nb) or tantalum (Ta). Although these materials are softer than NbTiN and are therefore expected to be more easily left behind on the contact surface 14 of probe pads 13, these materials are nevertheless reasonably hard (scoring around 6 to 7 on the Mohs hardness scale) and are therefore able to scratch through an oxide layer on the surface 14. Furthermore, both materials are superconductors with reasonably high T_{c} values (critical temperature) thereby provide good coherence times to the superconductive circuit 8 if such fragments from the tips 22 are present during cryogenic operation of the chip. Therefore, these materials are advantageous for use in superconductive circuits 8 as well as for the outer layer 30 of the probe tip 25 of the present invention. Niobium and tantalum are currently not known to be suitable for being deposited by ALD and as a result would need to be evaporated or sputtered on the probes 24 and probe tips 25.

As illustrated in figure 4, the probe tip 25 may be moved in a conventional manner across the contact surface 14 of the probe pad 13. The material 33 of the tip 25 is of same hardness as the contact surface 14, which is of the same material 26. In other words, the superconductive material 26 of the probe pad 13 (first material) is the same as the superconductive material 33 of the probe tip 25 (second material). Therefore, not only does this reduce the chances on any fragments of the probe tip 25 to break off, but additionally if this does happen, the fragments 22 (as in figure 4) are of the same superconductive material 33 as the material 26 of the contact surface 14. The presence of such fragments therefore does not increase the contact resistance and thereby does not hamper the measurement of *the parameter* of device 11 of the superconductive circuit 8, and also is not expected to reduce cryogenic chip performance by their presence on the chip.

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

The present invention has been described in terms of some specific embodiments thereof. It will be appreciated that the embodiments shown in the drawings and described herein are intended for illustrated purposes only and are not by any manner or means intended to be restrictive on the invention. It is believed that the operation and construction of the present invention will be apparent from the foregoing description and drawings appended thereto. It will be clear to the skilled person that the invention is not limited to any embodiment herein described and that modifications are possible which should be considered within the scope of the appended claims. Also kinematic inversions are considered inherently disclosed and to be within the scope of the invention. Moreover, any of the components and elements of the various embodiments disclosed may be combined or may be incorporated in other embodiments where considered necessary, desired or preferred, without departing from the scope of the invention as defined in the claims.

In the claims, any reference signs shall not be construed as limiting the claim. The term 'comprising' and 'including' when used in this description or the appended claims should not be construed in an exclusive or exhaustive sense but rather in an inclusive sense. Thus the expression 'comprising' as used herein does not exclude the presence of other elements or steps in addition to those listed in any claim. Expressions such as "consisting of', when used in this description or the appended claims, should be construed not as an exhaustive enumeration but rather in an inclusive sense of "at least consisting of". Furthermore, the words 'a' and 'an' shall not be construed as limited to 'only one', but instead are used to mean 'at least one', and do not exclude a plurality. Features that are not specifically or explicitly described or claimed may be additionally included in the structure of the invention within its scope. Any of the claimed or disclosed devices or portions thereof may be combined together or separated into further portions unless specifically stated otherwise, without departing from the claimed invention. Expressions such as: "means for ..." should be read as: "component configured for ..." or "member constructed to ..." and should be construed to include equivalents for the structures disclosed. The use of expressions like: "critical", "preferred", "especially preferred" etc. is not intended to limit the invention. Additions, deletions, and modifications within the purview of the skilled person may generally be made without departing from the spirit and scope of the invention, as is determined by the claims. The invention may be practiced otherwise then as specifically described herein, and is only limited by the appended claims.

## Claims

1. Probe for use in a probe system for probing a superconductive circuit including at least one quantum device, wherein the quantum device comprises a probe pad made of first material for enabling measuring of a parameter of the quantum device, wherein under cryogenic device operating conditions the first material is a superconductor; and
wherein the probe is configured for probing the probe pad for performing said measuring, wherein the probe comprises a probe tip configured to be brought in contact with a contact surface of the probe pad; and
wherein the probe tip, on a side thereof which is configured to be brought in contact with the contact surface of the probe pad, comprises on an outer layer which is made of a second material, which second material is same as the first material.

2. Probe according to claim 1, wherein the outer layer of the second material is a coating, wherein the second material is a material suitable for being applied using a deposition method.

3. Probe according to claim 2, wherein the deposition method is at least one of: atomic layer deposition; chemical vapour deposition; or physical vapour deposition, such as sputtering or evaporation.

4. Probe according to any one of the preceding claims, wherein the second material is selected from a group comprising: niobium titanium nitride (NbTiN), niobium nitride (NbN), tintanium nitride (TiN), niobium (Nb) and tantalum (Ta).

5. Probe according to any one of the preceding claims, wherein the probe is made of a third material different from the second material.

6. Probe according to claim 5, wherein the third material is at least one of: tungsten (W), beryllium copper (BeCu), tungsten rhenium (WRe), osmium (Os), gold (Au), gold plated tungsten, copper (Cu), or a grade of steel.

7. Probe according to any one of the preceding claims, wherein the probe is made of the second material.

8. Method of probing a superconductive circuit including at least one quantum device for measuring of a parameter of the quantum device, wherein the quantum device comprises a probe pad made of first material, wherein the first material is configured for becoming superconductive under cryogenic device operation conditions at a temperature below a critical temperature associated with the first material; the method comprising the steps of:
probing the probe pad using a probe according to any one or more of claims 1-7, wherein the probe comprises a probe tip and wherein the probing is performed by bringing the probe tip in contact with a contact surface of the probe pad;
wherein the probe tip, on a side thereof which is configured to be brought in contact with the contact surface of the probe pad, comprises on an outer layer which is made of a second material, which second material is same as the first material.

9. Method according to claim 8, wherein the second material is selected from a group comprising: niobium titanium nitride (NbTiN), niobium nitride (NbN), tintanium nitride (TiN), niobium (Nb) and tantalum (Ta).

10. Method according to claim 8 or 9, wherein the probe is made of a third material different from the second material.

11. Method according to claim 10, wherein the third material is at least one of: tungsten (W), beryllium copper (BeCu), tungsten rhenium (WRe), osmium (Os), gold (Au), gold plated tungsten, copper (Cu), or a grade of steel.

12. Method according to any one of the claims 8-11, wherein the probe is made of the second material.

13. Method according to any one of the claims 8-12, wherein the superconductive circuit is at least one of: a quantum chip; a quantum computing circuit; a superconducting amplifier, such as a superconducting parametric amplifier.

14. Method of manufacturing a probe according to any one or more of the claims 1-7, for probing a superconductive circuit including at least one quantum device for measuring of a parameter of the quantum device, wherein the quantum device comprises a probe pad made of first material, wherein the first material is configured for becoming superconductive under cryogenic device operation conditions at a temperature below a critical temperature associated with the first material; the method comprising the steps of:
providing a probe including a cantilever and a probe tip made of a third material; and
depositing, on the probe tip, on a side thereof which is configured to be brought in contact with a contact surface of the probe pad, an outer layer which is made of a second material, which second material is same as the first material.

15. Method according to claim 14, wherein at least one of:
the deposition method is at least one of: atomic layer deposition; chemical vapour deposition; or physical vapour deposition, such as sputtering or evaporation; or
the second material is selected from a group comprising: niobium titanium nitride (NbTiN), niobium nitride (NbN), tintanium nitride (TiN), niobium (Nb) and tantalum (Ta); or
the third material is at least one of: tungsten (W), beryllium copper (BeCu), tungsten rhenium (WRe), osmium (Os), gold (Au), gold plated tungsten, copper (Cu), or a grade of steel; or
the third material is same as the first and the second material.
